# EUROPÄISCHE PATENTSCHRIFT

(11) **EP 1 538 684 B1**
(45) Veröffentlichungstag und Bekanntmachung des Hinweises auf die Patenterteilung: **10.12.2008**
(21) Anmeldenummer: 04002303.8
(22) Anmeldetag: 03.02.2004
(51) Int. Cl.: H01L 51/30, H05B 33/14, H01L 31/00, C09K 11/06

(54) **Verfahren zur Dotierung von organischen Halbleitern mit Dioxaborinderivaten**
Process for doping organic semiconductors with derivatives of dioxaborine
Méthode de dopage des semi-conducteurs organiques avec des dérivés de dioxaborine

(30) Priorität: 04.12.2003 DE 10357044
(43) Veröffentlichungstag der Anmeldung: 08.06.2005
(60) Teilanmeldung: 05008447.4
(73) Patentinhaber: Novaled AG, 01307 Dresden (DE)
(72) Erfinder: Kühl, Olaf, Dr., 04416 Markkleeberg (DE); Hartmann, Horst, 01326 Dresden (DE); Zeika, Olaf, 06727 Theissen (DE); Pfeiffer, Martin, Dr., 01139 Dresden (DE); Zheng, Youxuan, 01069 Dresden (DE)
(74) Vertreter: Bittner, Thomas L.

(56) Entgegenhaltungen:
- EP-A- 0 293 749
- WO-A-02/064600
- DE-C- 10 152 938
- PFEIFFER M ET AL: "Controlled p-doping of pigment layers by cosublimation: Basic mechanisms and implications for their use in organic photovoltaic cells" SOLAR ENERGY MATERIALS AND SOLAR CELLS, ELSEVIER SCIENCE PUBLISHERS, AMSTERDAM, NL, Bd. 63, Nr. 1, Juni 2000 (2000-06), Seiten 83-99, XP004201249 ISSN: 0927-0248
- LUNARDI G ET AL: "N,N'-DICYANOQUINONEDIIMINES AS A MOLECULAR CONSTITUENT OF ORGANIC CONDUCTORS: VIBRATIONAL BEHAVIOR AND ELECTRON-MOLECULAR VIBRATION COUPLING" JOURNAL OF CHEMICAL PHYSICS, NEW YORK, NY, US, Bd. 95, Nr. 9, 1. November 1991 (1991-11-01), Seiten 6911-6923, XP009038182 ISSN: 0021-9606

## Beschreibung

Die Erfindung betrifft die Verwendung einer organischen mesomeren Verbindung als organischer Dotand zur Dotierung eines organischen halbleitenden lochleitenden Matrixmaterials zur Veränderung der elektrischen Eigenschaften desselben, ein dotiertes halbleitendes Matrixmaterial sowie ein aus diesem hergestelltes elektronisches Bauelement.

Schon seit einigen Jahrzehnten ist das Dotieren von Siliziumhalbleitern Stand der Technik. Danach wird durch Erzeugung von Ladungsträgern im Material eine Erhöhung der zunächst recht niedrigen Leitfähigkeit sowie je nach Art des verwendeten Dotanden eine Veränderung im Fermi-Niveau des Halbleiters erreicht.

Seit einigen Jahren ist nun aber auch bekannt geworden, dass man organische Halbleiter ebenfalls durch Dotierung hinsichtlich ihrer elektrischen Leitfähigkeit stark beeinflussen kann. Solche organischen halbleitenden Matrixmaterialien können entweder aus Verbindungen mit guten Elektronendonator-Eigenschaften oder aus Verbindungen mit guten Elektronenakzeptor-Eigenschaften aufgebaut werden. Zum Dotieren von Elektronendonator-Materialien sind starke Elektronen-Akzeptoren wie Tetracyanochinondimethan (TCNQ) oder 2,3,5,6-Tetrafluorotetracyano-1,4-benzochinondimethan (F4TCNQ) bekannt geworden.

M. Pfeiffer, A. Beyer, T. Fritz, K. Leo, Appl. Phys. Lett., 73 (22), 3202-3204 (1998). und J. Blochwitz, M. Pfeiffer, T. Fritz, K. Leo, Appl. Phys. Lett., 73 (6), 729-731 (1998). Diese erzeugen durch Elektronentransferprozesse in elektronendonatorartigen Basismaterialien (Löchertransportmaterialien) sog. Löcher, durch deren Anzahl und Beweglichkeit sich die Leitfähigkeit des Basismaterials mehr oder weniger signifikant verändert. Als Matrixmaterialien mit Löchertransporteigenschaften sind beispielsweise N,N'-perarylierte Benzidine **TPD** oder N,N',N"-perarylierte Starburstverbindungen, wie die Substanz **TDATA**, oder aber auch bestimmte Metallphthalocyanine, wie insbesondere Zinkphthalocyanin **ZnPc** bekannt.

Die bisher untersuchten Verbindungen haben jedoch für eine technische Anwendung Nachteile in der Produktion dotierter halbleitender organischer Schichten oder von entsprechenden elektronischen Bauteilen mit derartigen dotierten Schichten, da die Fertigungsprozesse in großtechnischen Produktionsanlagen oder solchen im Technikumsmaßstab nicht immer ausreichend präzise gesteuert werden können, was zu hohem Steuerungs- und Regelaufwand innerhalb der Prozesse führt, um eine gewünschte Produktqualität zu erzielen, oder zu unerwünschten Toleranzen der Produkte. Ferner bestehen Nachteile bei der Verwendung bisher bekannter organischer Donatoren bezüglich der elektronischen Bauelementstrukturen wie Leuchtdioden (OLEDs), Feldeffekttransistor (FET) oder Solarzellen selber, da die genannten Produktionsschwierigkeiten bei der Handhabung der Dotanden zu unerwünschten Ungleichmäßigkeiten in den elektronischen Bauteilen oder unerwünschten Alterungseffekten der elektronischen Bauteile führen können. Gleichzeitig ist jedoch zu beachten, dass die zu verwendenden Dotanden geeignete Elektronenaffinitäten und andere für den Anwendungsfall geeignete Eigenschaften aufweisen, da beispielsweise die Dotanden unter gegebenen Bedingungen auch die Leitfähigkeit oder andere elektrische Eigenschaften der organisch halbleitenden Schicht mit bestimmen.

Aus WO 02/064600 A1 sind amorphe organische 1,3,2-Dioxaborinluminophore mit halbleitenden Eigenschaften sowie deren Herstellung und ihre Anwendung in organischen Leuchtdioden und organischen Solarzellen bekannt.

Der Erfindung liegt daher die Aufgabe zugrunde, organische Dotanden zur Dotierung organischer Halbleiter bereitzustellen, die im Produktionsprozess leichter handhabbar sind und die zu elektronischen Bauteilen führen, deren organische halbleitende Materialien reproduzierbarer herstellbar sind.

Die Aufgabe wird gelöst, durch die Merkmale der unabhängigen Ansprüchen. Bevorzugte Ausführungsformen ergeben sich aus dem Unteransprüchen.

Erfindungsgemäß wird diese Aufgabe durch eine Verwendung einer organischen mesomeren Verbindung als organischer Dotand gelöst, die ein 1,3,2-Dioxaborin oder 1,3,2-Dioxaborinderivat, insbesondere ein unsubstituiertes, substituiertes oder anelliertes 1,3,2-Dioxaborin oder 1,3,2-Dioxaborinderivat ist und die unter gleichen Verdampfungsbedingungen eine geringere Flüchtigkeit als Tetrafluorotetracyanochinondimethan (F4TCNQ) aufweist, wobei das molare Dotierungverhältnis von Dotand zu Matrixmolekül bzw. monomeren Einheit eines polymeren Matrixmoleküls zwischen 1:5 bis 1:1000 beträgt. Durch die höhere Verdampfungstemperatur bzw. geringere Flüchigkeit unter gleichen Bedingungen können die Produktionsprozesse besser kontrolliert und damit mit geringerem Aufwand und reproduzierbarer durchgeführt werden, wobei durch die Bereitstellung von 1,3,2-Dioxaborinen bzw. deren Derivaten als Dotanden diese in den jeweiligen Bauteilen bei geringen Diffusionskoeffizienten, die zeitlich gleichbleibende Bauelementstrukturen gewährleisten, eine ausreichende elektrische Leitfähigkeit der organischen halbleitenden Matrix bei günstiger Elektronenaffinität der Dotanden ermöglichen. Ferner kann durch die Dotanden die Ladungsträgerinjektion von Kontakten in die dotierte Schicht verbessert werden. Ferner kann das dotierte organische Halbleitermaterial bzw. das resultierende elektronische Bauteil aufgrund der erfindungsgemäß verwendeten Verbindungen eine verbesserte Langzeitstabilität aufweisen. Dies betrifft beispielsweise eine Verringerung der Dotandenkonzentration mit der Zeit. Ferner betrifft dies die Stabilität der dotierten Schicht, die benachbart zu undotierten Schichten eines elektrooptischen Bauteils angeordnet ist, so dass elektrooptische Bauteile mit erhöhter Langzeitstabilität der elektrooptischen Eigenschaften wie Lichtausbeute bei einer vorgegebenen Wellenlänge, Wirksamkeit einer Solarzelle oder dergleichen resultieren.

Die Flüchtigkeit kann hierbei als der unter gleichen Bedingungen (beispielsweise einem Druck von 2 x 10⁻⁴ Pa und einer vorgegebenen Verdampfungstemperatur, beispielsweise 150°C) gemessene Verdampfungsrate oder als Bedampfungsrate eines Substrats gemessen als Schichtdickenwachstum je Zeiteinheit (nm/s) unter sonst gleichen Bedingungen bestimmt werden. Vorzugsweise beträgt die Flüchtigkeit der erfindungsgemäßen Verbindungen das ≤ 0,95- oder 0,9-fache, besonders bevorzugt das ≤ 0,8-fache, weiter bevorzugt das ≤ 0,5-fache, besonders bevorzugt das ≤ 0,1-fache oder das ≤ 0,05-fache oder ≤ 0,01-fache von F4TCNQ oder weniger.

Die Bedampfungsrate des Substrats mit den erfindungsgenäßen Verbindungen kann beispielsweise unter Verwendung eines Quartzdickenmonitors bestimmt wird, wie er beispielsweise bei der Herstellung von OLEDs üblicherweise eingesetzt wird. Insbesondere kann das Verhältnis der Bedampfungsraten von Matrixmaterialien und Dotanden durch unabhängige Messungen derselben unter Verwendung von zwei getrennten Quartzdickenmonitoren gemessen werden, um das Dotierungsverhältnis einzustellen.

Die Flüchtigkeit relativ zu der von F4TCNQ kann sich jeweils auf die der reinen Verbindung oder auf die Flüchtigkeit aus einem gegebenen Matrixmaterial, beispielsweise ZnPc, beziehen.

Es versteht sich, dass die erfindungsgemäß verwendeten Verbindungen vorzugsweise derart beschaffen sind, dass sie mehr oder weniger oder praktisch unzersetzt verdampfen. Es können unter Umständen jedoch auch zielgerichtet Precursor als Dotandenquelle eingesetzt werden, die die erfindungsgemäß verwendeten Verbindungen freisetzen, beispielsweise Säureadditionssalze, beispielsweise einer flüchtigen oder nichtflüchtigen anorganischen oder organischen Säure, oder Charge-Transfer-Komplexe derselben, wobei die Säuren bzw. Elektronen-Donatoren vorzugsweise nicht oder nur gering flüchtig sind oder der Charge-Transfer-Komplex selber als Dotand wirkt.

Vorzugsweise ist der Dotand derart ausgewählt, dass er unter sonst gleichen Bedingungen wie insbesondere Dotierungskonzentration (Molverhältnis Dotand:Matrix, Schichtdicke, Stromstärke) bei gegebenem Matrixmaterial (beispielsweise Zinkphtalocyanin oder einem anderen weiter unten genannten Matrixmaterial) eine genau so hohe oder vorzugsweise eine höhere Leitfähigkeit erzeugt als F4TCNQ, beispielsweise eine Leitfähigkeit (S/cm) von größer/gleich dem 1,1-fachen, 1,2-fachen oder größer/gleich dem 1,5-fachen oder zweifachen derjenigen von F4TCNQ als Dotand.

Vorzugsweise ist der erfindungsgemäß verwendete Dotand derart ausgewählt, dass das mit diesem dotierte halbleitende organische Matrixmaterial nach einer Temperaturänderung von 100°C auf Raumtemperatur (20°C) noch ≥ 20%, vorzugsweise ≥ 30%, besonders bevorzugt ≥ 50% oder 60% der Leitfähigkeit (S/cm) des Wertes bei 100°C aufweist.

Als Dotanden für die genannten bevorzugten Lochtransportmaterialen HT können erfindungsgemäß 1,3,2-Dioxaborine zum Einsatz kommen .

### 1,3,2-Dioxaborine

Erfindungsgemäß können ferner 1,3,2-Dioxaborinverbindungen zur Dotierung von halbleitenden organischen Materialien eingesetzt werden.

Die erfindungemäß verwendeten 1,3,2-Dioxaborinverbindungen weisen die allgemeine Formel L 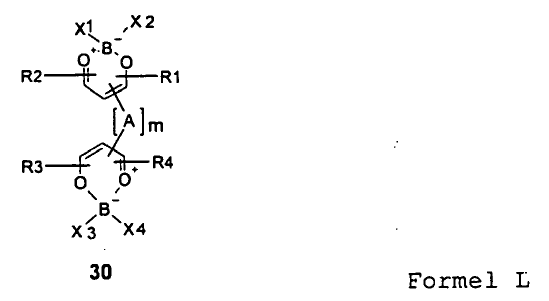 auf, wobei A ein bivalenter Rest ist, der ein oder mehrere Kohlenstoffatome aufweisen kann, die teilweise oder vollständig durch Heteroatome ersetzt sein können, wobei m = 0 oder eine ganze Zahl größer 0 ist, beispielsweise 1,2,3,4,5,6 oder größer ist, beispielsweise bis 10 oder bis 20, und wobei X ein einzähliger Ligand ist oder zwei Liganden X zusammen einen zweizähligen Liganden bilden können. Die Brücke Aₘ kann hierbei bis zu 6, bis zu 10 oder bis zu 20 Brückenatome, die die beiden 1,3,2-Dioxaborinringe miteinander verbinden, aufweisen, wobei die Brückenatome insbesondere Kohlenstoffatome und/oder Heteroatome sein können.

Die erfindungemäß verwendeten 1,3,2-Dioxaborinverbindung weisen alternativ die allgemeine Formel LI 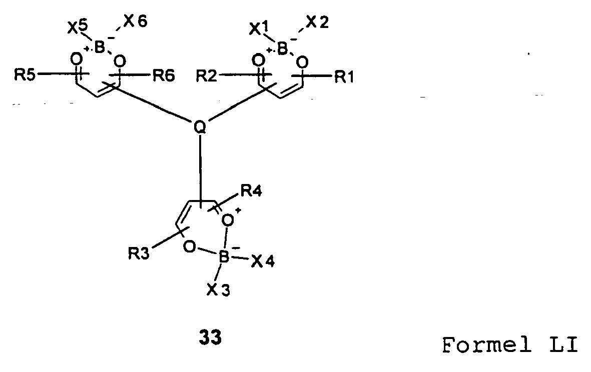 auf, wobei Q ein trivalenter Rest ist und wobei X ein einzähliger Ligand ist oder wobei zwei Liganden X zusammen einen zweizähligen Liganden bilden.

Ferner weisen alternativ die erfindungemäß verwendeten 1,3,2-Dioxaborinverbindungen die allgemeine Formel LII 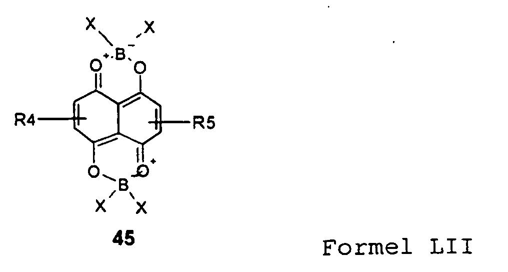 auf, die einen Unterfall der Formel L mit m = 0 darstellt, wobei die beiden 1,3,2-Dioxaborine jedoch mesomer miteinander verbunden sind.

Insbesondere können die hier als Dotanden vorgeschlagenen 1,3,2-Dioxaborine die allgemeinen Formeln **30** - **33** besitzen. 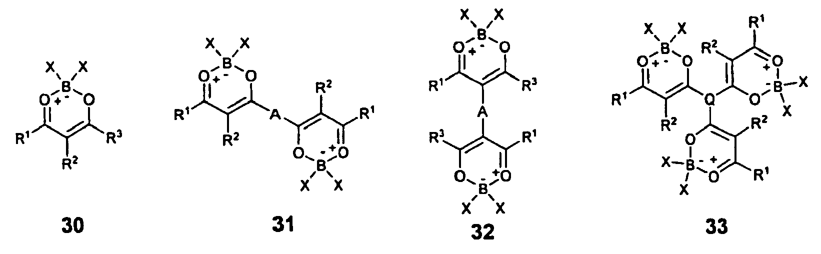 wobei in den Formeln jeweils die verschiedenen X und/oder R1 bis R3 untereinander gleich oder verschieden sein können.

Die angegebenen Symbole bedeuten folgendes:
die Reste X einen einzähligen Liganden mit einem vorzugsweise elektronegativen Haftatom, wie beispielsweise Fluor, Alkoxy, Acyloxy, Aryloxy oder Aroyloxy, einen zweizähligen Liganden, dessen Haftatome vorzugsweise Sauerstoff darstellen, die über eine Brücke mit unterschiedlichen Atomgruppierungen und variabler Anzahl von Brückenatomen miteinander verknüpft sind, wobei durch die Brücke vorzugsweise ein 5- oder 6-gliedriger Ring erzeugt wird, wobei zumindest ein Atom oder alle Atome der Brücke vorzugsweise ein Kohlenstoffatom sind,
   die Reste R¹ - R⁶, die jeweils voneinander unabhängig sein können, entweder Wasserstoff, eine Kohlenwasserstoffgruppe, die gegebenenfalls ein oder mehrere Heteroatome aufweisen kann, insbesondere Alkyl- oder Cycloalkylgruppe, die vorteilhafterweise teilweise oder vollständig durch Fluor oder Chlor substituiert, insbesondere perhalogeniert, besonders bevorzugt perfluoriert, sein kann und aus bevorzugt einem bis sechs oder acht oder zehn Kohlenstoffatomen (vorzugsweise maximal zehn Kohlenstoffatomen), die entweder verzweigt oder unverzweigt miteinander verknüpft sind, besteht, eine unsubstituierte oder substituierte Arylgruppe Ar, einschließlich Heteroarylgruppe, die ebenfalls vorteilhafterweise durch Halogen, insbesondere Fluor oder Chlor substituiert sein können, insbesondere perhalogeniert, im Besonderen perfloriert sein können, aber auch gemeinsam bei benachbarter Stellung am 1,3,2-Doxaborin-Gerüst mit den sie verbindenden Kohlenstoffatomen ein aromatisches, heteroaraomatisches oder nichtaromatisches Molekülfragment bilden kann, wie beispielsweise ein Benzo-, Naphtho-, Anthraceno-, Thieno-, Furano-, Benzothiopheno-, Benzofurano-, Indolo-, Carbazolo-, Chinolino-, Tetrahydronaphtho- oder Tetrahydrochinolino-Fragment, wobei diese Fragmente noch in sehr flexibler Weise, wie beispielsweise durch Halogene, wie Fluor oder Chlor, sowie durch andere heteroatomhaltige Gruppierungen, wie Alkyoxy-, Aryloxy-, Dialkylamino- oder Diarylamino-Gruppierungen, substituiert sein können,
   die Gruppierung A entweder eine Bindung zwischen den 1,3,2-Dioxaborin-Resten oder aber eine Brücke mit vorzugsweise bis zu zehn Atomen, wobei die Brücke Kohlenstoffatome oder auch Heteroatome wie beispielsweise O, N, S oder P aufweisen kann, und wobei die Kohlenstoffatome teilweise oder vollständig durch Heteroatome ersetzt sein können. Gegebenenfalls kann die Brücke mehrere oder ausschließlich ungesättigte Brückenatome aufweisen. Die Brücke stellt vorzugsweise, ebenso wie Q, ein die Konjugation zwischen den 1,3,2-Dioxaborin-Resten vermittelndes Molekülfragment dar, beispielsweise dadurch, dass sämtliche Brükkenatome der Brücke ungesättigt sind,
   die Gruppierung Q entweder einen trivalenten Rest wie ein Stickstoff- oder Phosphoratom, eine Trialkylen- oder Triarylen- bzw. Triheteroarylenamino- oder Phosphorgruppe. Die Brücke vor Q stellt vorzugsweise ein die Konjugation zwischen den 1,3,2-Dioxaborin-Resten vermittelndes Molekülfragment dar.

Stellen die Reste X in den Verbindungen der Formeln L, LI oder LII, insbesondere in Verbindungen des Formeltyps **30** - **33** einen zweizähligen Liganden dar, handelt es sich vorzugsweise um die Reste von organischen Dicarbonsäuren, wie insbesondere Oxalsäure oder Malonsäure, Bernsteinsäure sowie Glutarsäure, wobei diese Dicarbonsäuren mit Ausnahme der erstgenannten Verbindungen in ihren Alkylengruppierungen noch durch Alkyl- oder Arylgruppierungen substituiert sein können, um die Reste von aromatischen Dicarbonsäuren, wie Phthalsäure und ihren im Ring vorzugsweise durch Halogen substituierten Derivaten, organischen Hydroxysäuren, wie Salicylsäure und ihren Ring-substituierten Derivaten, 1-Hydroxy-naphthalin-2-carbonsäure, 2-Hydroxynaphthalin-1-carbonsäure, Mandelsäure, Weinsäure, Benzilsäure und ihren in den Phenylresten substituierten Derivaten, um 1,2-Dioxyaren-oder Dioxyhetaren-Reste, die sich vom Brenzkatechin und seinen im Ring substituierten oder durch Benzoreste kondensierten Derivaten, aber auch von 3,4-Dioxythiophenen ableiten, um Reste von cyclischen Oxodicarbonsäuren, wie Quadrat-, Krokonsäure oder dergleichen.

Die Gruppierungen A bzw. Q, deren Aufgabe vorzugsweise die Herstellung der Konjugation zwischen den einzelnen, sie verbindenden 1,3,2-Dioxaborin-Resten ist, können eine sehr große strukturelle Vielfalt aufweisen und stellen bevorzugt eine bi- bzw. tri-valente Atomgruppierung, wie Sauerstoff, Schwefel bzw. Stickstoff oder mehrere miteinander in konjugativer Weise verknüpfte bivalente bzw. trivalente Arylgruppierung(en), Heteroarylgruppierung(en), Polyenyl- oder Polymethinyl-Gruppierung(en) dar, wobei die jeweiligen Gruppierungen noch weitere Substituenten tragen können, die insbesondere Alkylgruppen mit 1 bis 10 Kohlenstoffatomen, die zudem noch durch Fluor oder Chlor substituiert sein können, insbesondere perhalogeniert oder perfluoriert, unsubstituierte oder vorzugsweise durch Fluor oder Chlor sowie durch elektronenziehende Substituenten modifizierte Aryl- oder Heteroaryl-Gruppierungen sein können, wobei die Heteroatome in letzteren bevorzugt Sauerstoff, Schwefel oder Stickstoff sein und sowohl einzeln als auch in Kombination miteinander auftreten können, oder aber auch in geeignete Brückengruppierungen, wie Cycloalkylen-Gruppierungen oder ihren heterocyclischen Analoga eingebaut sein können.

Symbolisiert A oder Q eine Arylgruppierung, so ist diese im Falle von A bevorzugt eine oder mehrere der Gruppierungen **34** - **36** und im Falle von Q eine oder gegebenenfalls auch mehrere der Gruppierungen **37** - **39**, wobei diese durch übliche Substituenten, die vorzugsweise elektronegative Haftatome tragen, substituiert sein können und in den Fragmenten des Typs **36** die Reste R⁵ und R⁶, die gleich oder verschieden sein können, entweder Wasserstoff, Alkyl oder Fluor sowie Chlor, aber vorzugsweise auch gemeinsam ein durch n-, iso- oder cylco-Alkylgruppen mit 1 - 10 C-Atomen substituiertes Kohlenstoffatom sein kann, wobei in Verbindung 35 oder 39 vorzugsweise n eine ganze Zahl zwischen 1 und 4 sein kann. W kann eine trivalente Gruppe oder ein trivalentes Atom wie insbesondere N oder P oder die Gruppe 42 sein, ohne hierauf beschränkt zu sein.

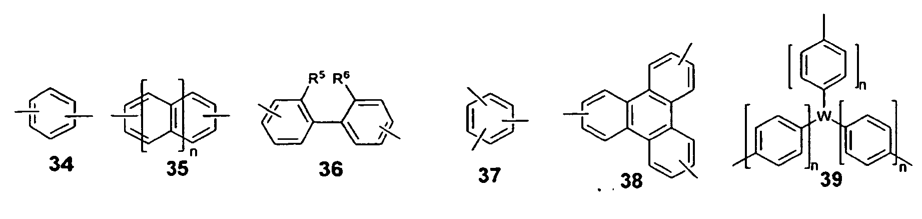

Symbolisiert A oder Q eine Hetarylgruppe, so stellen diese bevorzugt im Falle von A eine Gruppierung der allgemeinen Formel **40** oder **41** dar, wobei gegebenenfalls in der Gruppe A auch Einleiten nach den Formeln 40 und 41 kombiniert auftreten können, und im Falle von Q eine Gruppierung der allgemeinen Formel **42** dar, in denen die Reste R⁷ bzw. R⁸ beliebige Substituenten, wie beispielsweise Alkyl- Aryl- oder Heteroaryl- sowie Halogen oder Alkoxy, Aryloxy, Dialkylamino oder Diarylamino, und die Gruppierungen Z¹ - Z⁶ bivalente Heteroatome, wie vorzugsweise Sauerstoff, Schwefel oder unsubstituierter oder substituierter Stickstoff oder Phosphor, sowie n eine ganze Zahl, bevorzugt zwischen 1 und 4 oder 6 sein können, insbesondere 1, 2 oder 3.

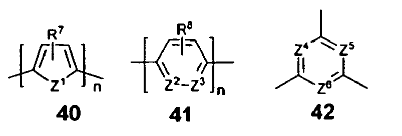

Zu den erfindungsgemäßen Verbindungen des Typs **30 - 33** gehören auch solche, bei denen die vorgenannten Brückengruppierungen auch in Kombination miteinander angetroffen werden können, wie das beispielsweise für eine Oxybiphenylen- oder Thiophenylen-Einheit sowie eine Aminotriphenylen-Einheit der Fall ist, wobei die Verknüpfung mit dem jeweiligen 1,3,2-Dioxaborinsystem in jeder beliebigen Stellung zum Heteroatom, vorzugsweise jedoch in einer 1,4-Verknüpfung, möglich ist. Zu den erfindungsgemäßen Verbindungen gehören auch solche, bei denen neben den genannten Brückengruppierungen A und Q noch einer der am 1,3,2-Dioxaborin-System haftenden Reste mit in die jeweilige Brückengruppierung einbezogen werden, so dass Verbindungen der allgemeinen Formeln **43** - **46** entstehen, in denen die Gruppierungen X sowie R¹ - R³ die oben angegebene und R⁹ eine der Reste R¹ - R³ entsprechende Bedeutung besitzen.

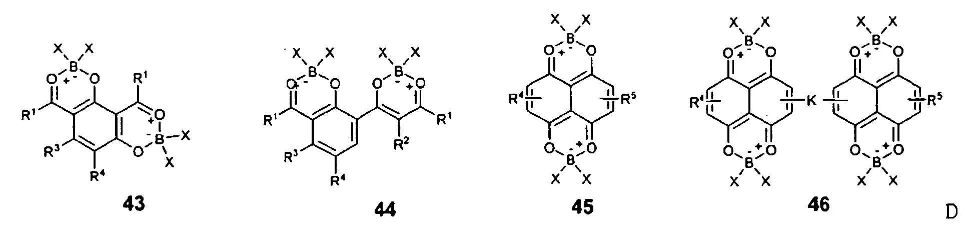

Das Symbol K steht für eine Gruppierung, die die beiden flankierenden 1,3,2-Dioxaborin-haltigen Molekülstrukturen verknüpft, vorzugsweise konjugativ miteinander verknüpft, was beispielsweise durch eine direkte Fusion der beiden Flankengruppierungen oder unter Einbau eines Aryl- oder Hetarylfragmentes möglich ist.

Die folgenden Verbindungen sollen die erfindungsgemäß einsetzbaren 1,3,2-Dioxaborine beispielhaft veranschaulichen:

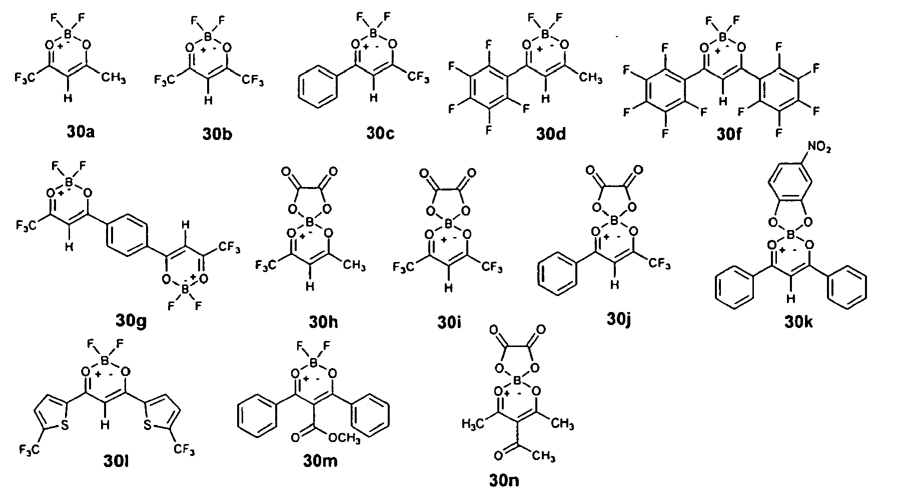

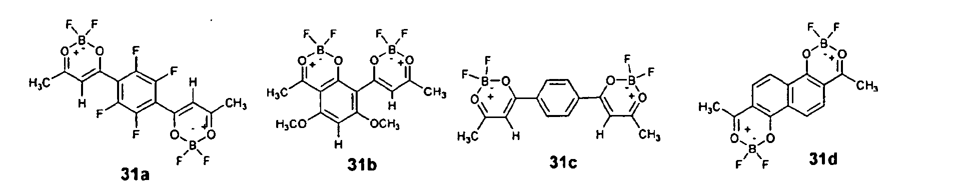

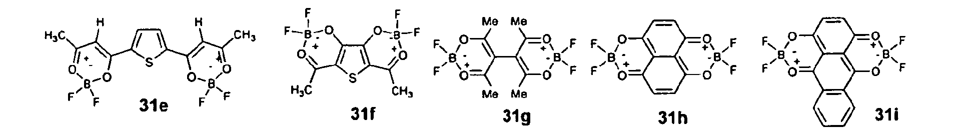

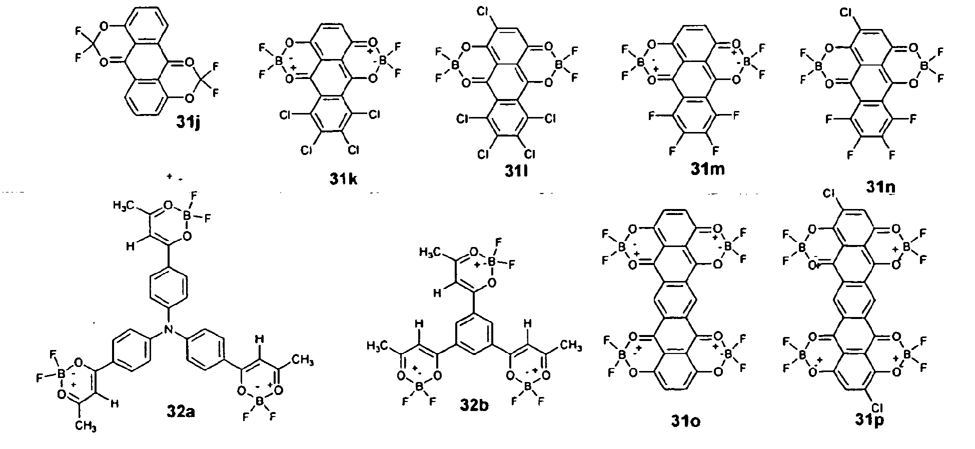

Die Verbindungen 31f bis i stellen Verbindungen des Formeltyps L mit m = 0 dar.

Die Verbindungen 30g, 31a bis e und 31j stellen Verbindungen des Formeltyps L mit m = 1 dar, wobei im Falle der Verbindung 31 b A gleich -C(=CR1R2)- und m gleich 1 ist, wobei im Falle der Verbindung 31 d und j A gleich -CR1=CR2- und m gleich 1 ist.

Die Verbindungen 32a und b stellen Verbindungen des Formeltyps LI dar.

Die Verbindungen 31k bis n und o,p stellen Verbindungen des Formeltyps LII dar.

### Darstellung der 1,3,2-Dioxaborine

### 1,4-Bis-(2,2-difluor-4-methyl-1,3,2-dioxaborinyl)-benzol:

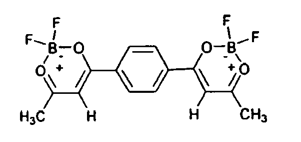

Zu einer Lösung von 1,4-Diacetylbenzol (0,01 Mol) in Acetanhydrid (50 mL) wird bei Raumtemperatur unter Rühren Bortrifluorid-Etherat (10 mL) zugetropft. Nach Stehen über Nacht wird der ausgefallene Feststoff abgesaugt und dieser mit Ether gewaschen. F. 293-298 °C.

### 5,7-Bismethoxy-2,2-difluor-4-methyl-8-(2,2-difluor-4-methyl-1,3,2-dioxaborinyl)-benzo[d]1,3,2-dioxaborin:

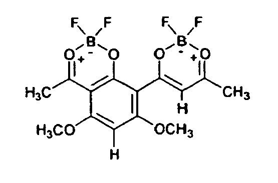

Zu einer Lösung von 1,3,5-Trimethoxy-benzol (0,1 Mol) in Acetanhydrid (0,9 Mol) wird bei Raumtemperatur unter Rühren Bortrifluorid/Essigsäure (0,3 Mol) zugetropft. Nach Stehen über Nacht wird der ausgefallene Feststoff abgesaugt, mit Ether gewaschen und aus Toluol/Nitromethan umkristallisiert. F. 217-219 °C.

### 2,2,7,7-Tetrafuor-2,7-dihydro-1,3,6,8-doxa-2,7-dibora-pyren:

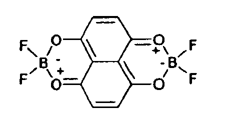

1g 5,8-Dihydroxy-1,4-naphthochinon und 1,5ml BF₃-Etherat wurden in trockenen Toluen 2 h auf dem Wasserbad unter Rühren erhitzt. Nach dem Abkühlen auf Raumtemperatur scheidet sich ein rot-brauner kristalliner Niederschlag ab, der aus trockenem Eisessig umkristallisiert werden kann. F. 163-165 °C.

### 2,2,7,7-Tetrafuor-2,7-dihydro-1,3,6,8-doxa-2,7-diborabenzo[e]pyren :

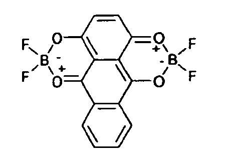

10g Chinizarin und 10 ml BF₃-Etherat wurden in trockenem Toluen 2 h auf dem Wasserbad unter Rühren erhitzt. Nach dem Abkühlen auf Raumtemperatur scheidet sich ein rot-brauner kristalliner Niederschlag ab, der aus trockenem Eisessig umkristallisiert werden kann. F. 249-251 °C.

### 2,2,8,8-Tetrafluor-2,8-dihydro-1,3,7,9-tetraoxa-2,8-diboraperylen

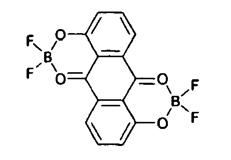

10g 1,5-Dihydroxy-9,10-anthrachinon und 10 ml BF₃-Etherat wurden in trockenem Toluen 2 h auf dem Wasserbad unter Rühren erhitzt. Nach dem Abkühlen auf Raumtemperatur scheidet sich ein rot kristalliner Niederschlag ab, der aus trockenem Eisessig umkristallisiert werden kann. F. > 350 °C.

### Tris-[4-(2,2-difluor-4-methyl-1,3,2-dioxaborinyl)-phenyl]-amin:

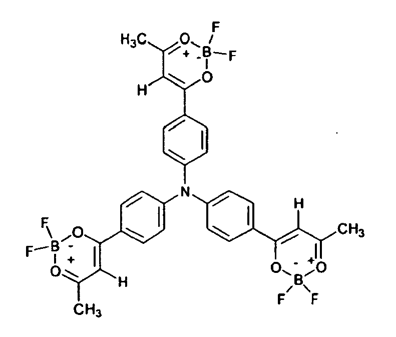

Zu einer Lösung von Triphenylamin (0,1 Mol) in Acetanhydrid (0, 9 Mol) wird bei Raumtemperatur unter Rühren Bortrifluorid/Essigsäure (0,3 Mol) zugetropft. Nach Stehen über Nacht wird der ausgefallene Feststoff abgesaugt, mit Ether gewaschen und aus Eisessig/Nitromethan umkristallisiert. F. 305-307 °C.

### 1,3,5-Tris-(2,2-difluor-4-methyl-1,3,2-dioxaborinyl)-benzol:

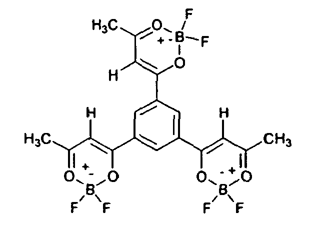

Zu einer Mischung aus Acetanhydrid (0,6 Mol) und Bortrifluorid-Essigsäure (0,2 Mol) werden unter Rühren bei 45 °C 1,3,5-Triaceteylbenzol (0,05 Mol) langsam zugetropft. Die resultierende Mischung wird noch 8 Std. weiter gerührt und dann Erkalten gelassen. Das nach Zugabe von Diethylether (100 mL) ausfallende Produkt wird abgesaugt, mit Essigester gewaschen und aus Nitromethan umkristallisiert, F. > 360 °C.

### 7,9-Dimethyl-1,4,6,10-tetraoxa-5-bora-spiro[4.5]deca-7,9-dien-2,3-dion:

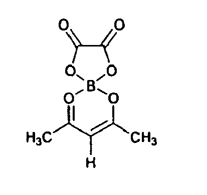

Acetylaceton (0,1 Mol), Oxalsäure (0,1 Mol) und Borsäure (0,1 Mol) werden in Toluol (200 mL) solange erhitzt, bis eine klare Lösung entstanden ist und sich kein Wasser mehr abscheidet. Nach dem Erkalten wird das ausgefallene Produkt abgesaugt und mit Cyclohexan gewaschen. F. 187-189 °C.

### 8-Acetyl-7,9-dimethyl-1,4,6,10-tetraoxa-5-bora-spiro[4.5]deca-7,9-dien-2,3-dion:

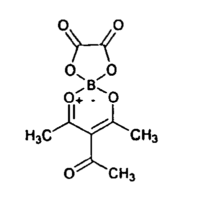

Triacetylmethan (0,1 Mol) und Bortrifluorid-Etherat (0,15 Mol) werden in Ether (200 mL) 20 Std. bei Raumtemperatur gerührt. Anschießend wird das ausgefallene Produkt abgesaugt und mit Cyclohexan gewaschen. F. > 250°C.

### 2,3-Benzo-7,9-bis-(4-chlorphenyl)-1,4,6,10-tetraoxa-5-boraspiro[4.5]deca-7,9-diene:

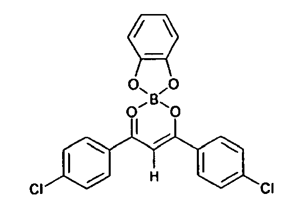

Brenzkatechin (0,1 Mol), Bis-(4-chlorbenzoyl)-methan (0,1 Mol), und Borsäure (0,1 Mol) werden in Toluol (250 mL) solange erhitzt, bis eine klare Lösung entstanden ist und sich kein Wasser mehr abscheidet. Nach dem Erkalten wird das ausgefallene Produkt abgesaugt und mit Cyclohexan gewaschen. F. 312-315 °C.

### Matrixmaterialien

In der vorliegenden Erfindung werden geeignete Dotanden für organische halbleitende Materialien wie Lochtransportmaterialen **HT** beschrieben, die üblicherweise in OLEDs oder organischen Solarzellen verwendet werden. Die halbleitenden Materialien sind vorzugsweise intrinsisch lochleitend. Für erfindungsgemäße Dotanden des Dioxaborin-Typs kann das Folgende gelten.

Das Matrixmaterial kann teilweise (> 10 oder > 25 Gew.-%) oder im Wesentlichen (> 50 Gew.-% oder > 75 Gew.-%)) oder vollständig bestehen aus einem Metallphtalocyanin-Komplex, einem Porphyrin-Komplex, insbesondere Metallporphyrinkomplex, einer Oligothiophen-, Oligophenyl-, Oligophenylenvinylen oder Oligofluoren-Verbindung, wobei das Oligomere vorzugsweise 2-500 oder mehr, vorzugsweise 2-100 oder 2-50 oder 2-10 monomere Einheiten umfasst. Gegebenenfalls kann das Oligomer auch > 4, > 6 oder > 10 oder mehr monomere Einheiten umfassen, insbesondere auch für die oben angegebenen Bereiche, also beispielsweise 4 oder 6-10 monomere Einheiten, 6 oder 10-100 monomere Einheiten oder 10-500 monomere Einheiten. Die Monomere bzw. Oligomere können substituiert oder unsubstituiert sein, wobei auch Block- oder Mischpolymerisate aus den genannten Oligomeren vorliegen können, einer Verbindung mit einer Triarylamin-Einheit oder eine Spiro-Bifluoren-Verbindung. Die genannten Matrixmaterialien können auch in Kombination miteinander vorliegen, gegebenenfalls auch in Kombination mit anderen Matrixmaterialien. Die Matrixmaterialien können elektronenschiebende Substituenten wie Alkyl- oder Alkoxy-Reste aufweisen, die eine verminderte Ionisierungsenergie aufweisen oder die Ionisierungsenergie des Matrixmaterials vermindern.

Die als Matrixmaterial eingesetzten Metallphtalocyaninkomplexe oder Porphyrinkomplexe können ein Hauptgruppenmetallatom oder Nebengruppenmetallatom aufweisen. Das Metallatom Me kann jeweils 4-, 5- oder 6-fach koordiniert sein, beispielsweise in Form von Oxo- (Me=O), Dioxo- (O=Me=O), Imin-, Diimin-, Hydroxo-, Dihydroxo-, Amino- oder Diaminokomplexen, ohne hierauf beschränkt zu sein. Der Phtalocyaninkomplex oder Porphyrinkomplex kann jeweils teilweise hydriert sein, wobei jedoch vorzugsweise das mesomere Ringsystem nicht gestört wird. Die Phtalocyaninkomplexe können als Zentralatom beispielsweise Magnesium, Zink, Eisen, Nickel, Kobalt, Magnesium, Kupfer oder Vanadyl (= VO) enthalten. Die gleichen oder andere Metallatome bzw. Oxometallatome können im Falle von Porphyrinkomplexen vorliegen.

Insbesondere können solche dotierbaren Lochtransportmaterialen **HT** arylierte Benzidine, beispielsweise N,N'-perarylierte Benzidine oder andere Diamine wie des Typs **TPD** (wobei eine, mehrere oder sämtliche der Arylgruppen aromatische Heteroatome aufweisen können), geeignete arylierte Starburst-Verbindungen wie N,N',N''-perarylierte Starburstverbindungen, wie die Verbindung **TDATA** (wobei eine, mehrere oder sämtliche der Arylgruppen aromatische Heteroatome aufweisen können), sein. Die Arylreste können insbesondere für jede der oben genannten Verbindungen Phenyl, Naphtyl, Pyridin, Chinolin, Isochinolin, Peridazin, Pyrimidin, Pyrazin, Pyrazol, Imidazol, Oxazol, Furan, Pyrrol, Indol oder dergleichen umfassen. Die Phenylgruppen der jeweiligen Verbindungen können durch Thiophengruppen teilweise oder vollständig ersetzt sein.

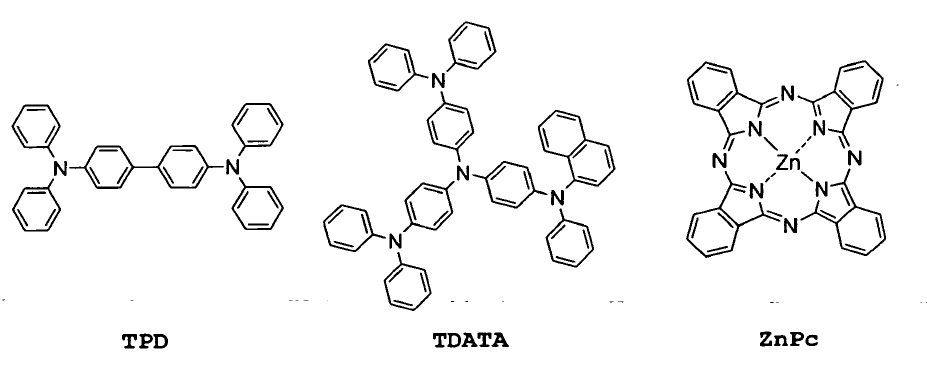

Vorzugsweise besteht das verwendete Matrixmaterial vollständig aus einem Metallphtalocyanin-Komplex, einem Porphyrin-Komplex, einer Verbindung mit einer Triarylamin-Einheit oder einer Spiro-Bifluoren-Verbindung.

Es versteht sich, dass auch geeignete andere organische Matrixmaterialien, insbesondere lochleitende Materialien verwendet werden können, die halbleitende Eigenschaften aufweisen.

### Dotierung

Die Dotierung kann insbesondere derart erfolgen, dass das molare Verhältnis von Matrixmolekül zu Dotand oder im Falle von oligomeren Matrixmaterialien das Verhältnis von Matrixmonomerenanzahl zu Dotand 1:5 bis 1:1000 beispielsweise 1:10 bis 1:100, beispielsweise ca. 1:50 bis 1:100 oder auch 1:25 bis 1:50 beträgt.

### Verdampfung der Dotanden

Die Dotierung des jeweiligen Matrixmaterials (hier vorzugsweise angegeben als löcherleitendes Matrixmaterial HT) mit den erfindungsgemäß zu verwendenden Dotanden kann durch eines oder eine Kombination der folgenden Verfahren hergestellt wird:
a) Mischverdampfung im Vakuum mit einer Quelle für HT und einer für den Dotand.
b) Sequentielles Deponieren von HT und Dotand mit anschliessender Eindiffusion des Dotanden durch thermische Behandlung
c) Dotierung einer HT-Schicht durch eine Lösung von Dotanden mit anschliessendem Verdampfen des Lösungsmittels durch thermische Behandlung
d) Oberflächendotierung einer HT-Schicht durch eine oberflächlich aufgebrachte Schicht von Dotanden

Die Dotierung kann derart erfolgen, dass der Dotand aus einer Precursor-Verbindung heraus verdampft wird, die beim Erhitzen und/oder Bestrahlung den Dotanden freisetzt. Die Bestrahlung kann mittels elektromagnetischer Strahlung, insbesondere sichtbarem Licht, UV-Licht oder IR-Licht erfolgen, beispielsweise jeweils Laserlicht, oder auch durch andere Strahlungsarten. Durch die Bestrahlung kann im wesentlichen die zur Verdampfung notwendige Wärme bereitgestellt werden, es kann auch gezielt in bestimmte Banden der zu verdampfenden Verbindungen bzw. Precursor oder Verbindungskomplexe wie Charge-Transfer-Komplexe eingestrahlt werden, um beispielsweise durch Überführung in angeregte Zustände die Verdampfung der Verbindungen durch Dissoziation der Komplexe zu erleichtern. Es versteht sich, dass die nachfolgend beschriebenen Verdampfungsbedingungen sich auf solche ohne Bestrahlung richten und für Vergleichszwecke einheitliche Verdampfungsbedingungen heranzuziehen sind.

Als Precursorverbindungen könne beispielsweise zum Einsatz kommen:
a) Gemische oder stöchiometrische oder mischkristalline Verbindungen aus dem Dotand und einer inerten, nicht-flüchtigen Substanz, z.B. einem Polymer, Molsieb, Aluminiumoxid, Kieselgel, Oligomeren oder einer anderen organischen oder anorganischen Substanz mit hoher Verdampfungstemperatur, wobei der Dotand vorwiegend durch van-der-Waals Kräfte und/oder Wasserstoffbrükkenbindung an dieser Substanz gebunden ist.
b) Gemisch oder stöchiometrische oder mischkristalline Verbindung aus dem Dotand und einer mehr oder weniger Elektronendonor-artigen, nicht flüchtigen Verbindung V, wobei ein mehr oder weniger vollständiger Ladungstransfer zwischen dem Dotanden und der Verbindung V auftritt, wie in Charge-Transfer-Komplexen mit mehr oder weniger elektronenreichen Polyaromaten oder Heteroaromaten oder einer anderen organischen oder anorganischen Substanz mit hoher Verdampfungstemperatur.
c) Gemisch oder stöchiometrische oder mischkristalline Verbindung aus dem Dotand und einer Substanz, welche zusammen mit dem Dotand verdampft und eine gleiche oder höhere Ionisierungsenergie aufweist wie die zu dotierende Substanz HT, so dass die Substanz in dem organischen Matrixmaterial keine Haftstelle für Löcher bildet. Hierbei kann die Substanz erfindungsgemäß auch mit dem Matrixmaterial identisch sein, beispielsweise ein Metallphtalocyanin oder Benzidin-Derivat darstellen. Weitere geeignete flüchtige Co-Substanzen, wie Hydrochinone, 1,4-Phenylendiamine oder 1-Amino-4-hydroxybenze oder sonstige Verbindungen bilden Chinhydrone oder andere Charge-Transfer-Komplexe.

### Elektronisches Bauelement

Unter Verwendung der erfindungsgemäßen organischen Verbindungen zur Herstellung dotierter organischer halbleitender Materialien, die insbesondere in Form von Schichten oder elektrischen Leitungspfaden angeordnet sein können, können eine Vielzahl elektronischer Bauelemente oder diese enthaltende Einrichtungen hergestellt werden. Insbesondere können die erfindungsgemäßen Dotanden zur Herstellung von organischen lichtemitierenden Dioden (OLED), organischen Solarzellen, organischen Dioden, insbesondere solchen mit hohem Gleichrichtungsverhältnis wie 10³-10⁷, vorzugsweise 10⁴-10⁷ oder 10⁵-10⁷ oder organischen Feldeffekttransistoren verwendet werden. Durch die erfindungsgemäßen Dotanden kann die Leitfähigkeit der dotierten Schichten und/oder die Verbesserung der Ladungsträgerinjektion von Kontakten in die dotierte Schicht verbessert werden. Insbesondere bei OLEDs kann das Bauelement eine pin-Struktur oder eine inverse Struktur aufweisen, ohne hierauf beschränkt zu sein. Die Verwendung der erfindungsgemäßen Dotanden ist jedoch auf die oben genannten vorteilhaften Ausführungsbeispiele nicht beschränkt.

### Ausführungsbeispiele

Die Erfindung soll an einigen Ausführungsbeispielen näher erläutert werden.

Die erfindungsgemäß zu verwendenden Verbindungen, insbesondere die vorstehend beispielhaft angebenen Verbindungen aus der vorstehend beschriebenen Stoffklasse der 1,3,2-Dioxaborine, werden nun in folgender Weise als Dotanden für verschiedene Lochleiter verwendet, die ihrerseits zum Aufbau bestimmter mikroelektronischer oder optoelektronischer Bauelemente, wie z.B. einer OLED, benutzt werden. Hierbei können die Dotanden gleichzeitig nebeneinander mit dem Lochtransportmaterialien der Matrix im Hochvakuum (ca. 2x 10⁻⁴ Pa) bei erhöhten Temperaturen verdampft werden. Eine typische Substratbedampfungsrate für das Matrixmaterial ist 0,2 nm/s (Dichte ca. 1,5 g/cm³). Die Bedampfungsraten für die Dotanden können variieren zwischen 0.001 und 0.5 nm/s bei gleicher angenommener Dichte, jeweils entsprechend dem gewünschten Dotierungsverhältnis. Im nachfolgenden werden die Verdampfungstemperaturen der Verbindungen in einer Substratbedampfungseinrichtung angegeben, wobei F4TCNQ unter sonst identischen Bedingungen eine Verdampfungstemperatur von 80°C aufweist, um bei gleicher vorgegebener Zeiteinheit (z.B. fünf Sekunden) eine gleiche Schichtdicke (z.B. 1 nm) auf dem Substrat abzuscheiden, wie die erfindungsgemäß verwendeten Dotanden.

In den folgenden Beispielen wurden die Strommessungen über einen 1 mm langen und ca. 0,5 mm breiten Strompfad aus dem dotierten HT-Material bei 1V durchgeführt. Unter diesen Bedingungen leitet ZnPc praktisch keinen elektrischen Strom.

### Beispiel 1

### Dotierung von ZnPc mit 2,2,7,7-Tetrafluor-2,7-dihydro-1,3,6,8-doxa-2,7-dibora-pentachloro-benzo[e]pyren.

Die Verdampfungstemperatur T(evap.) beträgt 140°C. Die Schicht wurde im Verhältnis 1:25 (Dotand:Matrix) im Vakuum aufgedampft. Dabei wurde eine Leitfähigkeit von 2.8×10⁻⁵ S/cm gemessen.

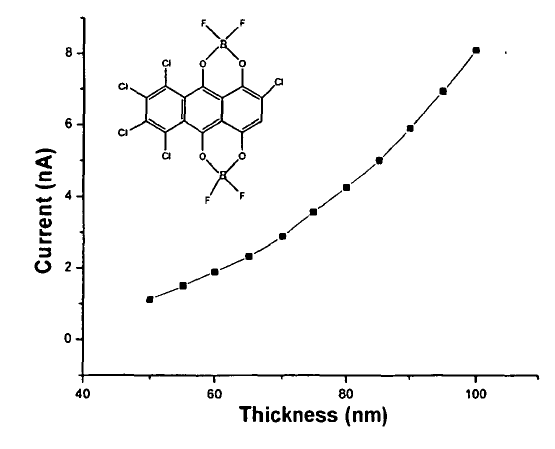

| Thickness (nm) | Current (nA) |
|---|---|
| 50 | 1.12 |
| 55 | 1.49 |
| 60 | 1.89 |
| 65 | 2.32 |
| 70 | 2.88 |
| 75 | 3.56 |
| 80 | 4.25 |
| 85 | 5 |
| 90 | 5.9 |
| 95 | 6.94 |
| 100 | 8.1 |

## Patentansprüche

1. Verwendung einer organischen mesomeren Verbindung als organischer Dotand zur Dotierung eines (metall)organischen halbleitenden lochleitenden Matrixmaterials zur Veränderung der elektrischen Eigenschaften desselben, wobei die mesomere Verbindung ein 1,3,2-Dioxaborin oder ein 1,3,2-Dioxaborinderivat ist und die mesomere Verbindung unter gleichen Verdampfungsbedingungen eine geringere Flüchtigkeit als Tetrafluorotetracyanochinondimethan (F4TCNQ) aufweist, wobei das molare Dotierungverhältnis von Dotand zu Matrixmolekül bzw. monomeren Einheit eines polymeren Matrixmoleküls zwischen 1:5 bis 1:1000 beträgt, **dadurch gekennzeichnet, dass** die mesomere 1,3,2-Dioxaborinverbindung die allgemeine Formel L 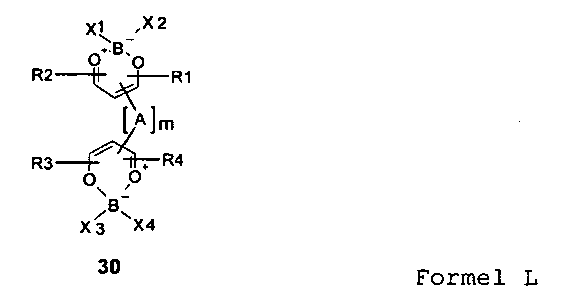 hat,
wobei A ein bivalenter Rest ist, der ein oder mehrere Kohlenstoffatome aufweisen kann, die teilweise oder vollständig durch Heteroatome ersetzt sein können, wobei m = 0 oder eine ganze Zahl größer 0 ist, und wobei X ein einzähliger Ligand ist, wobei zwei Liganden X einen zweizähligen Liganden bilden können,
oder dass die mesomere 1,3,2-Dioxaborinverbindung die allgemeine Formel LI 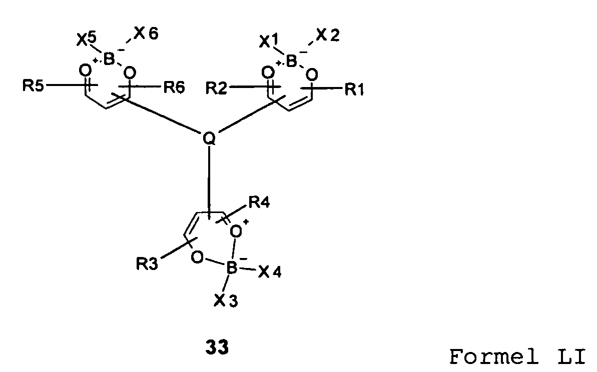 hat,
wobei Q ein trivalenter Rest ist
wobei X ein einzähliger Ligand ist, wobei zwei Liganden X einen zweizähligen Liganden bilden können, wobei R¹-R⁶, jeweils unabhängig voneinander, substituiert oder unsubstituiert, Alky, Cycloalkyl, Aryl oder Heteroaryl sind oder benachbarte R¹-R⁶ am 1,3,2-Dioxaboringerüst mit den sie verbindenden Kohlenstoffatomen ein aromatisches, heteroaromatisches oder nicht-aromatisches Molekülfragment bilden, oder dass die mesomere 1,3,2-Dioxaborinverbindung die allgemeine Formel LII 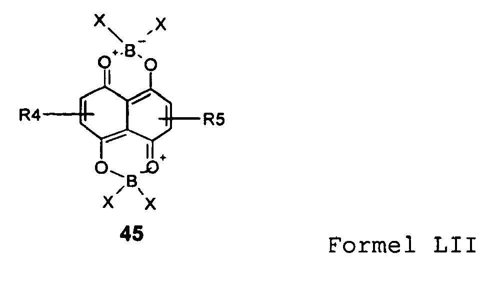 hat,
wobei X ein einzähliger Ligand ist, wobei zwei Liganden X einen zweizähligen Liganden bilden können und wobei die R4, R5 organische Reste sind, die 1,3,2-Dioxaborinringe aufweisen können.

2. Verwendung einer Verbindung nach Anspruch 1, **dadurch gekennzeichnet, dass** A ausgewählt ist aus der Gruppe bestehend aus 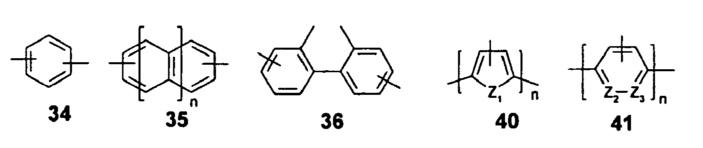 und -(C(R1)=C(R2)-)n mit n gleich 1,2,3,4, 5 oder 6 und -NR1-, wobei Z₁, Z₂ und Z₃ bi- oder trivalente Atome sind, und wobei einer oder beide Reste R1, R2 mit einem oder beiden benachbarten 1,3,2-Dioxaborinringen einen Ring bilden kann.

3. Verwendung einer Verbindung nach Anspruch 1, **dadurch gekennzeichnet , dass** Q ausgewählt ist aus der Gruppe bestehend aus 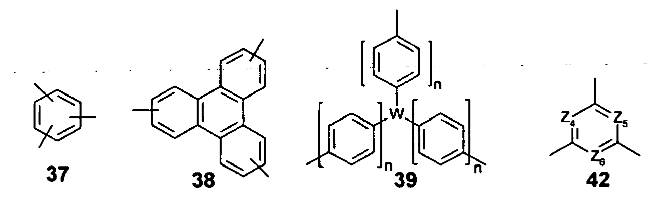 Stickstoff, N(Aryl)3, wobei Aryl Heteroaryl umfasst, Phosphor und P(Aryl)3, wobei Aryl Heterorayl umfasst, wobei Z⁴ , Z⁵ und Z⁶ trivalente Atome sind, und wobei W ein trivalentes Atom oder eine trivalente Atomgruppe ist, wobei n gleich 0, 1, 2, 3 oder 4 sein kann.

4. Verwendung einer Verbindung nach einem der Ansprüche 1 bis 3, **dadurch gekennzeichnet, dass** die Verbindung 1,2,3,4,5 oder 6 Arylreste aufweist, die jeweils untereinander oder mit einem oder mehreren 1,3,2-Dioxaborinringen der Verbindung anelliert sind.

5. Verwendung einer Verbindung nach einem der Ansprüche 1 bis 4, **dadurch gekennzeichnet, dass** die Verbindung 2,2,7,7-Tetrafluor-2,7-dihydro-1,3,6,8-doxa-2,7-dibora-pentachloro-benzo[e]pyren ist.

6. Verwendung einer Verbindung nach einem der Ansprüche 1 bis 5, **dadurch gekennzeichnet, dass** das Matrixmaterial teilweise oder vollständig besteht aus einem Metallphtalocyanin-Komplex, einem Porphyrin-Komplex, einer Oligothiophenverbindung, Oligophenylverbindung, Oligophenylenvinylenverbindung, Oligofluoren-Verbindung, einer Pentazenverbindung, einer Verbindung mit einer Triarylamin-Einheit und/oder einer Spiro-Bifluoren-Verbindung.

7. Organisches halbleitendes Material enthaltend ein organisches lochleitendes Matrixmolekül und einen organischen Dotanden, **dadurch gekennzeichnet , dass** der Dotand eine oder mehrere Verbindungen nach einem der Ansprüche 1 bis 6 sind und dass das molare Dotierungsverhältnis von Dotand zu Matrixmolekül bzw. monomeren Einheit eines polymeren Matrixmoleküls zwischen 1:5 und 1:1000 beträgt.

8. Verfahren zur Herstellung eines organischen halbleitenden Materials enthaltend ein organisches Matrixmolekül und einen organischen Dotanden nach Anspruch 7, **dadurch gekennzeichnet, dass** der Dotand aus einer Precursor-Verbindung heraus verdampft wird, die beim Erhitzen und/oder Bestrahlung den Dotanden freigibt.

9. Elektronisches Bauelement mit einem organischen halbleitenden lochleitenden Material, welches mit einem organischen Dotanden zur Veränderung der elektronischen Eigenschaften des halbleitenden lochleitenden Matrixmaterials dotiert ist, wobei die Dotierung unter Verwendung zumindest einer oder mehrerer der Verbindungen nach einem der Ansprüche 1 bis 6 erfolgte und wobei das molare Dotierungverhältnis von Dotand zu Matrixmolekül bzw, monomeren Einheit eines polymeren Matrixmoleküls zwischen 1:5 bis 1:1000 beträgt.

10. Elektronisches Bauelement nach Anspruch 9 in Form einer organischen lichtemitierenden Diode (OLED), einer photovoltaischen Zelle, einer organischen Solarzelle, einer organischen Diode oder eines organischen Feldeffekttransistors.

## Claims

1. The use of an organic mesomeric compound as an organic dopant for doping an organ(ometall)ic semiconducting hole-conducting matrix material to vary the electric properties thereof, the mesomeric compound being a 1,3,2-dioxaborinane or a 1,3,2-dioxaborinane derivative and the mesomeric compound having, under like vaporization conditions, a lower volatility than tetrafluorocyanoquinonedimethane (F4TCNQ), the molar doping ratio of dopant to matrix molecule, or a monomeric unit of a polymeric matrix molecule, being between 1:5 to 1:1000, **characterized in that** the mesomeric 1,3,2-dioxaborinane compound has the general formula L 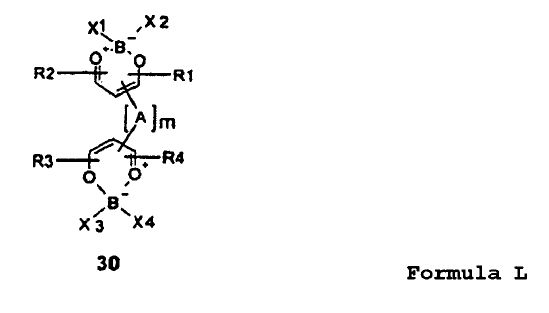 where A is a bivalent radical which may have one or more carbon atoms which may be partly or wholly replaced by heteroatoms, m is = 0 or is a whole number greater than 0, and X is a monodentate ligand such that two X ligands may combine to form one bidentate ligand,
or **in that** the mesomeric 1,3,2-dioxaborinane compound has the general formula LI 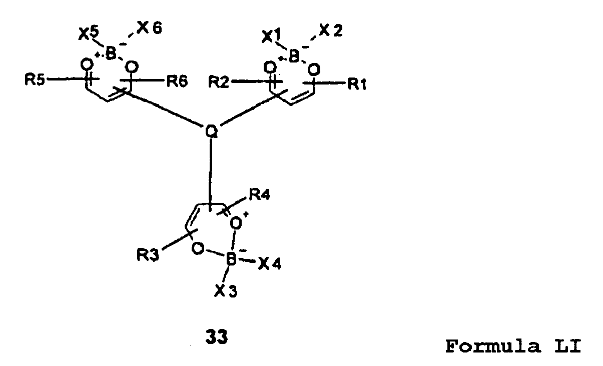 where Q is a trivalent radical,
where X is a monodentate ligand such that two X ligands may combine to form one bidentate ligand,
where R¹-R⁶ are each independently substituted or unsubstituted alkyl, substituted or unsubstituted cycloalkyl, substituted or unsubstituted aryl or substituted or unsubstituted heteroaryl or adjacent R¹-R⁶ on the 1,3,2-dioxaborinane scaffold combine with the joining carbon atoms to form an aromatic, heteroaromatic or nonaromatic molecular fragment, or **in that** the mesomeric 1,3,2-dioxaborinane compound has the general formula LII 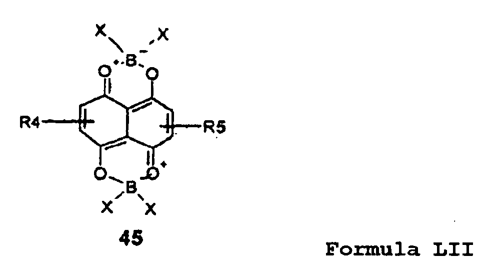 where X is a monodentate ligand such that two X ligands are capable of forming one bidentate ligand and where R4, R5 are organic radicals with or without 1,3,2-dioxaborinane rings.

2. The use of a compound according to claim 1, **characterized in that** A is selected from the group consisting of 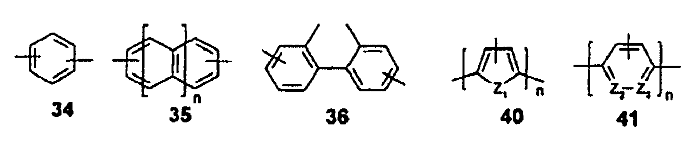 and -(C(R1)=C(R2)-)n where n is 1, 2, 3, 4, 5 or 6 and -NR1-, where Z₁, Z₂ and Z₃ are bi- or trivalent atoms and where one or both of R1 and R2 may combine with either or both adjacent 1,3,2-dioxaborinane rings to form a ring.

3. The use of a compound according to claim 1, **characterized in that** Q is selected from the group consisting of 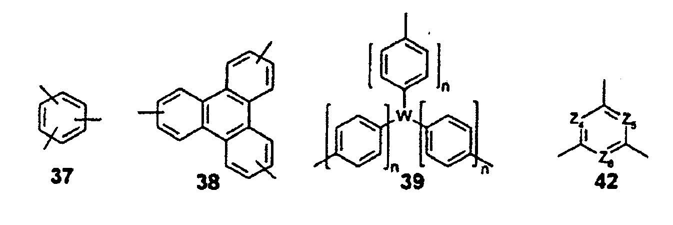 nitrogen, N(aryl)3, where aryl comprises heteroaryl, phosphorus and P(aryl)3, where aryl comprises heteroaryl, where Z⁴, Z⁵ and Z⁶ are trivalent atoms, and where W is a trivalent atom or a trivalent group of atoms, and n may be equal to 0, 1, 2, 3 or 4.

4. The use of a compound according to any one of claims 1 to 3, **characterized in that** the compound comprises 1, 2, 3, 4, 5 or 6 aryl radicals which may each be anellated with each other or with one or more 1,3,2-dioxaborinane rings of the compound.

5. The use of a compound according to any one of claims 1 to 4, **characterized in that** the compound is 2,2,7,7-tetrafluoro-2,7-dihydro-1,3,6,8-tetraoxa-2,7-diborapentachlorobenzo[e]pyrene.

6. The use of a compound according to any one of claims 1 to 5, **characterized in that** the matrix material consists wholly or partly of a metal phthalocyanine complex, a porphyrin complex, an oligothiophene compound, an oligophenyl compound, an oligophenylenevinylene compound, an oligofluorane compound, a pentazene compound, a compound comprising a triarylamine unit and/or a spirobifluorene compound.

7. An organic semiconducting material containing an organic hole-conducting matrix molecule and an organic dopant, **characterized in that** the dopant comprises one or more compounds according to any one of claims 1 to 6 and **in that** the molar doping ratio of dopant to matrix molecule, or monomeric unit of a polymeric matrix molecule, is between 1:5 and 1:1000.

8. A method of preparing an organic semiconducting material containing an organic matrix molecule and an organic dopant according to claim 7, **characterized in that** the dopant is vaporized out of a precursor compound which releases the dopant on heating and/or irradiation.

9. An electronic component comprising an organic semiconducting hole-conducting material doped with an organic dopant to vary the electronic properties thereof, wherein the doping comprises using at least one or more of the compounds according to any one of claims 1 to 6 and wherein the molar doping ratio of dopant to matrix molecule, or monomeric unit of a polymeric matrix molecule, is between 1:5 to 1:1000.

10. An electronic component according to claim 9 in the form of an organic light-emitting diode (OLED), a photovoltaic cell, an organic solar cell, an organic diode or an organic field-effect transistor.

## Revendications

1. Utilisation d'un composé mésomère organique comme dopant organique pour le dopage d'un matériau matriciel semi-conducteur organique conducteur de trous (métallique) pour modifier les propriétés électriques de celui-ci, dans laquelle le composé mésomère est une 1,3,2-dioxaborine ou un dérivé de 1,3,2-dioxaborine et le composé mésomère présente une plus faible volatilité que le tétrafluorotétracyanochinonediméthane (F4TNCQ) dans des conditions d'évaporation identiques, le ratio de dopage molaire du dopant par rapport à la molécule matricielle ou à l'unité monomère d'une molécule polymère matricielle allant de 1:5 à 1:1000, **caractérisée en ce que** le composé de 1,3,2-dioxaborine mésomère présente la formule L 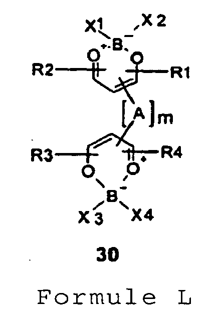 dans laquelle A est un radical bivalent, qui peut présenter un ou plusieurs atomes de carbone, qui peuvent être substitués partiellement ou totalement par des hétéroatomes, où m=0 ou un nombre entier supérieur à 0, et X est un ligand monovalent, deux ligands X pouvant former un ligand bivalent, ou bien **en ce que** le composé de 1,3,2-dioxaborine présente la formule générale LI 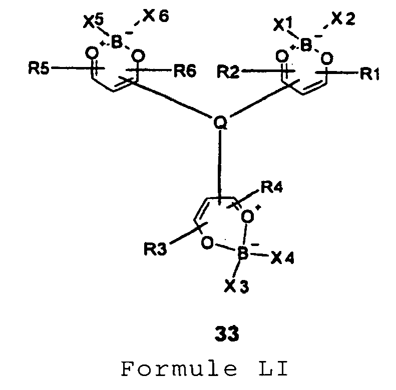 dans laquelle Q est un radical trivalent et
où X est un ligand monovalent, dans lequel deux ligands X peuvent former un ligand bivalent, où R¹-R⁶, indépendamment les uns des autres, sont un alcyle, cycloalcyle, aryle ou hétéroaryle substitué ou non substitué ou bien des R¹-R⁶ voisins de l'ossature de la 1,3,2-dioxaborine forment un fragment moléculaire aromatique, hétéroaromatique ou non-aromatique avec les atomes de carbone qui les relient, ou bien **en ce que** le composé 1,3,2-dioxaborine présente la formule LII 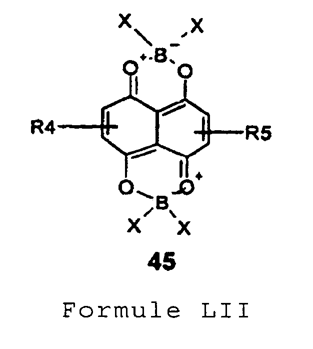 dans laquelle X est un ligand monovalent, deux ligands X pouvant former un ligand bivalent et où R4, R5 sont des résidus organiques, qui peuvent présenter des cycles de 1,3,2-dioxaborine.

2. Utilisation d'un composé selon la formule 1, **caractérisée en ce que** A est choisi parmi le groupe constitué de 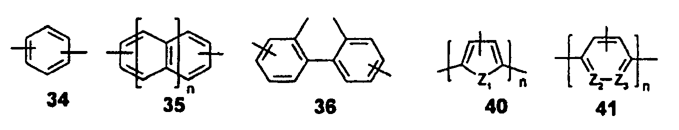 et-(C(R1)=C(R2)-)n avec n égal à 1, 2, 3, 4, 5 ou 6 et -NR1-, où Z₁, Z₂ et Z₃ sont des atomes bi- ou trivalents, et où l'un des deux radicaux R1, R2 ou les deux peuvent former un cycle avec l'un ou les deux cycles de 1,3,2-dioxaborine voisins.

3. Utilisation d'un composé selon la revendication 1, **caractérisée en ce que** Q est choisi parmi un groupe constitué de 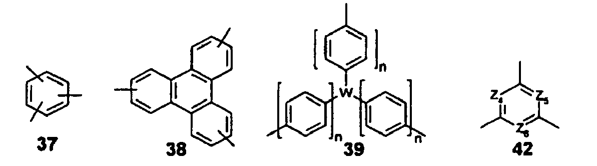 d'azote, N(aryle)3, où l'aryle comprend un hétéroaryle, du phosphore et P(aryle)3, où l'aryle comprend un hétéroaryle, dans lequel Z⁴, Z⁵ et Z⁶ sont des atomes trivalents, et où W est un atome trivalent ou groupe d'atomes trivalents, où n peut être égal à 0, 1, 2, 3 ou 4.

4. Utilisation d'un composé selon l'une des revendications 1 à 3, **caractérisée en ce que** le composé présente 1, 2, 3, 4, 5 ou 6 radicaux aryle, qui sont annelés entre eux ou avec un ou plusieurs des cycles de 1,3,2-dioxaborine.

5. Utilisation d'un composé selon l'une des revendications 1 à 4, **caractérisée en ce que** le composé est un 2,2,7,7-tétrafluoro-2,7-dihydro-1,3,6,8-doxa-2,7-dibora-pentachlorobenzo[e]pyrène.

6. Utilisation d'un composé selon l'une des revendications 1 à 5, **caractérisée en ce que** le matériau matriciel est constitué partiellement ou complètement d'un complexe de phtalocyanine métallique, d'un complexe de porphyrine, d'un composé d'oligothiopène, d'un composé d'oligophényle, d'un composé d'oligophénylvinyle, d'un composé d'oligofluorène, d'un composé pentazène, d'un composé ayant une unité triarylamine et/ou d'un composé spiro-bifluorène.

7. Matériau organique semi-conducteur contenant une molécule matricielle conducteur de trous organique et un dopant organique **caractérisé en ce que** le dopant est un ou plusieurs composés selon l'une des revendications 1 à 6, et **en ce que** le ratio molaire de dopage entre le dopant et la molécule matricielle ou l'unité monomère d'une molécule matricielle polymère va de 1:5 à 1:1000.

8. Procédé de fabrication d'un matériau semi-conducteur organique contenant une molécule matricielle organique et un dopant organique selon la revendication 7, **caractérisé en ce que** le dopant est évaporé à partir d'un composé précurseur, qui libère le dopant sous l'effet du réchauffement et/ou du rayonnement.

9. Élément électronique avec un matériau semi-conducteur organique conducteur de trous, qui est dopé avec un dopant organique afin de modifier les propriétés électroniques du matériau semi-conducteur conducteur de trous, dans lequel le dopage a lieu avec l'utilisation d'au moins un voire plusieurs composés selon l'une des revendications 1 à 6, et dans lequel le ratio molaire de dopage entre le dopant et la molécule matricielle ou l'unité monomère d'une molécule matricielle va de 1:5 à 1:1000.

10. Élément électronique selon la revendication 9 sous la forme d'une diode électroluminescente organique (DELO), d'une cellule photovoltaïque, d'une cellule solaire organique, d'une diode organique ou d'un transistor à effet de champ.
